Europäisches Patentamt

European Patent Office

Office européen des brevets

(11) Veröffentlichungsnummer: **0 167 713**

A2

(12) **EUROPÄISCHE PATENTANMELDUNG**

(21) Anmeldenummer: **85103635.0**

(22) Anmeldetag: **27.03.85**

(51) Int. Cl.⁴: **H 03 M 1/12**

(30) Priorität: **06.04.84 DE 3413051**

(43) Veröffentlichungstag der Anmeldung:
**15.01.86 Patentblatt 86/3**

(84) Benannte Vertragsstaaten:
**FR GB IT**

(71) Anmelder: **Werba, Hans**
**Theresienstrasse 11**
**D-8390 Passau(DE)**

(72) Erfinder: **Werba, Hans**
**Theresienstrasse 11**
**D-8390 Passau(DE)**

(74) Vertreter: **Klunker, Hans-Friedrich, Dr. et al,**
**Patentanwälte Klunker . Schmitt-Nilson . Hirsch**
**Winzererstrasse 106**
**D-8000 München 40(DE)**

(54) **Analog/Digital-Wandler.**

(57) A/D-Wandler, bei dem ein Trägerfrequenzsignal mit dem umzusetzenden Analogsignal frequenzmoduliert wird. Das frequenzmodulierte Signal wird parallel in eine Mehrzahl Resonananzeinrichtungen eingespeist, die je auf eine andere Resonanz-frequenz im maximal auftretenden Frequenzhub-bereich abgestimmt sind. Je nach dem, ob ein Resonator im Resonanzzustand ist oder nicht, wird ihm ein Logikwert "1" oder ein Logikwert "0" zugeordnet. Das dem Resonanzmuster aller Resonatoren entsprechende Logikwertmuster stellt dann den digitalisierten Momentanwert des Analogsignals dar.

./...

---

Analog/Digital-Wandler

---

*I*

Die Erfindung betrifft einen Analog/Digital-Wandler (im folgenden kurz A/D-Wandler bezeichnet) gemäß Oberbegriff des Anspruchs 1.

Herkömmliche A/D-Wandler weisen üblicherweise Schwellenwertschaltungen in Form von Komparatorschaltungen auf, die Transistoren enthalten, die je nach dem, ober der Schwellenwert überschritten ist oder nicht, im Sperrbereich oder im Sättigungsbereich arbeiten. Aufgrund der Zeitverzögerungseffekte, die zeitweise im Sättigungsbereich arbeitende Transistoren mit sich bringen, setzen solche A/D-Wandler dem zu digitalisierenden Analogsignal hinsichtlich der maximalen Frequenz Grenzen, die häufig nicht akzeptabel sind.

Außerdem werden bei derartigen herkömmlichen A/D-Wandlern mit Komparatorschaltungen die Vergleiche mit unterschiedlich großen Schwellenwerten nacheinander durchgeführt. Zunächst wird das umzusetzende Analogsignal mit der größten Stufe verglichen. Danach folgen hintereinander Vergleiche mit zunehmend kleineren Schwellen. Jede dieser Stufen kann ihren Vergleich mit der zugehörigen Schwelle erst dann durchführen, wenn der Vergleich mit der vorausgehenden größeren Schwelle abgeschlossen ist. Mit zunehmender Quantisierungsauflösung bei der Analog/Digital-Umsetzung benötigt man mehr Zeit für einen Umsetzvorgang, so daß die einzelnen A/D-Umsetzungen nur mit relativ großem Taktabstand durchgeführt werden können. Dies bedeutet aber, daß nur Analogsignale mit relativ niedriger Frequenz umgesetzt werden können.

Der Erfindung liegt die Aufgabe zugrunde, derartige Nachteile zu überwinden, insbesondere zu einem A/D-Wandler zu kommen, der die Umwandlung von Analogsignalen mit vergleichsweise hoher Frequenz ermöglicht.

Die Lösung dieser Aufgabe ist im Anspruch 1 angegeben und kann gemäß den Unteransprüchen vorteilhaft weitergebildet werden.

Durch die erfindungsgemäße Maßnahme, das Analogsignal nicht direkt umzusetzen sondern mittels Frequenzmodulation auf ein Trägersignal aufzumodulieren und das modulierte Signal gleichzeitig einer Anzahl von Resonanzeinrichtungen mit unterschiedlicher Resonanzfrequenz anzubieten, erreicht man, daß ein digitalisiertes Muster unmittelbar nach der Abgabe des modulierten Signals von der Modulationseinrichtung an den die Ausgänge des A/D-Wandlers bildenden Resonatoreinrichtungen gleichzeitig zur Verfügung steht. Die Umsetztaktfrequenz des erfindungsgemäßen A/D-Wandlers kann deshalb sehr hoch sein, weil die Umsetzung in den parallel arbeitenden Resonatoren praktisch ohne Zeitverzögerung vor sich geht. Somit können Analogsignale mit Frequenzen bis in den GHz-Bereich digitalisiert werden.

Die Wirkungsweise des erfindungsgemäßen A/D-Wandlers wird besonders anschaulich, wenn man ihn mit einem Zungenfrequenzmesser vergleicht, bei dem einem Kamm mit einer Mehrzahl resonanzfähiger Zungen unterschiedlicher Länge ein frequenzmäßig zunächst unbekanntes Signal angeboten wird
und anhand der jeweils schwingenden Zunge die Frequenz
festgestellt werden kann.

Bei dem erfindungsgemäßen A/D-Wandler können die einzelnen
Resonanzeinrichtungen durch Einzelresonatoren wie LC-Paral-
lel- oder Serienresonanzkreise, $\lambda$/4- oder $\lambda$/-2-Resona-
toren, Keramik-Resonatoren oder dergleichen gebildet sein.
Die einzelnen Resonanzeinrichtungen können jedoch auch
durch mehrere zusammengeschaltete Resonatoren gebildet
sein, wenn man besonders schmalbandige Resonanzeinrichtungen
mit hoher Güte benötigt, um eine möglichst hohe Umsetzgenauigkeit zu erzielen.

Zwischen den Ausgang der Modulationseinrichtung und die Eingänge der einzelnen Resonanzeinrichtungen schaltet man vorzugsweise Kopplungsglieder, die einerseits eine gute Ankopplung an die Modulationseinrichtung, andererseits eine
gute Entkopplung zwischen den einzelnen Resonanzeinrichtungen gewährleisten. Hierfür eignen sich beispielsweise Richtkoppler.

Das Binärmuster des digitalisierten Signals wird durch die
Schwingzustände der einzelnen Resonanzeinrichtungen dargestellt. Beispielsweise kann man einer im Resonanzzustand
befindlichen Resonanzeinrichtung den Logikwert "1" und
einer Resonanzeinrichtung, die sich im Nicht-Resonanzustand befindet, den Logikwert "Null" zuordnen. Selbstverständlich ist auch die umgekehrte Zuordnung möglich.

Bei einer besonders bevorzugten Ausführungsform des erfindungsgemäßen A/D-Wandlers ist jeder Resonanzeinrichtung
eine Schwellenwertschaltung nachgeschaltet, mittels welcher
das an der zugehörigen Resonanzeinrichtung auftretende Signal hinsichtlich seiner Bedeutung als Logikwert "1"
oder als Logikwert "0" definiert wird.

Die Resonanzeinrichtungen bzw. die Schwellenwertschaltungen
können je mit einer Stufe eines Speichers verbunden werden,
der das durch die jeweiligen Zustände der Resonanzeinrichtungen definierte digitale Muster übernehmen und speichern
kann.

Der erfindungsgemäße A/D-Wandler läßt sich in vorteilhafter
Weise als Stufenschalter einsetzen, der mehrere Schalterausgänge aufweist, an denen zu unterschiedlichen Zeiten Schaltsteuersignale erzeugt werden können. Dabei werden die einzelnen Schalterausgänge durch die einzelnen Ausgänge des
A/D-Wandlers gebildet. Zur Steuerung des Stufenschalters
legt man an die Modulationseinrichtung als Analogsignal ein
Schalterausgangsselektionssignal an, das zu einer Frequenzmodulation des Trägersignals auf eine momentane Frequenz
führt, auf welche die ausgewählte Resonanzeinrichtung anspricht. Bei Verwendung eines solchen Stufenschalters als
programmierbarer Schalter führt man der Modulationseinrichtung ein durch Programmierung vorbestimmtes Muster von
aufeinanderfolgenden  Schalterausgangsselektionssignalen
zu.

Ein solcher Stufenschalter läßt sich z.B. zur variablen
Steuerung von Multiplexsystemen verwenden, wobei durch das
Programm die Reihenfolge der nacheinander angesteuerten
Kanäle des Multiplexsystems geändert werden kann.

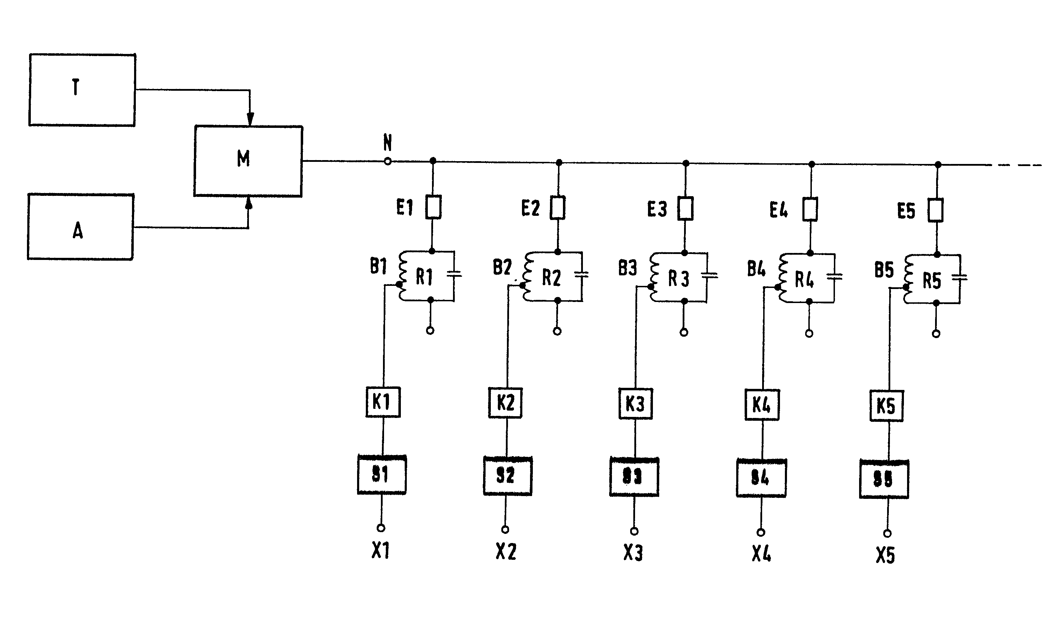

Die Erfindung und Weiterbildungen der Erfindung werden nun
anhand einer in der Zeichnung dargestellten Ausführungsform näher erläutert.

0167713

Bei der in der Figur dargestellten Auführungsform wird
einer Modulationseinrichtung M von einer Trägerfrequenzsignalquelle T eine Trägerfrequenz und von einer Analogsignalquelle A ein Analogsignal zugeführt. In der Modulationseinrichtung M wird die Trägerfrequenz mit dem
Analogsingal frequenzmoduliert. Bei praktischen Ausführungsformen wird man vorzugsweise den Trägerfrequenzoszillator
direkt mit dem Analogsignal modulieren, so daß die Modulationseinrichtung nicht als gesonderte Schaltungsvorrichtung ausgeführt sein muß.

An den Ausgang N der Modulationseinrichtung M ist eine
Mehrzahl von Resonanzeinrichtungen angeschlossen, die bei
der dargestellten Ausführungsform je durch einen LC-Parallel-
Resonanzkreis R1, R2,... R5 gebildet sind. Die Anzahl der
verwendeten Resonatoren hängt von der gewünschten Auflösung
bei der Analog/Digital-Umsetzung ab. Im speziellen Fall
können weniger oder mehr als fünf Resonatoren verwendet
werden.

Jeder dieser Resonatoren ist auf eine andere Resonanzfrequenz abgestimmt, die jedoch alle im verwendeten Frequenzhubbereich liegen. Zwischen den Ausgangsanschluß N
und die einzelnen Resonatoren R1, R2, ... ist je ein
Kopplungsglied E1, E2,... geschaltet, das einerseits für
eine gute Entkopplung von den übrigen Resonatoren sorgt,
andererseits eine gute Ankopplung an die Modulationseinrichtung ermöglichen soll. Geeignet sind beispielsweise
Richtkoppler, geeignet sind aber auch andere Kopplungsglieder, beispielsweise Kondensatoren.

Die Induktivitäten der einzelnen Resonatoren R1, R2,...
weisen Anzapfungen B1, B2,... auf, an denen ein Signal abgenommen werden kann, aus dem auf den Resonanz- oder
Nicht-Resonanz-Zustand des jeweiligen Resonantors geschlossen werden kann. Diesen Anzapfungen sind in der
dargestellten bevorzugten Ausführungsform Schwellenwertschaltungen S1, S2, ... nachgeschaltet, vorzugsweise über
Auskoppelglieder K1, K2, ..., mit denen eine zu starke
Belastung der Resonatoren und damit eine zu starke Verringerung vonderen Güte verhindert werden soll. Durch
Wahl der Ansprechschwelle der Schwellenwertschaltungen
wird definiert, in welchen Bereichen das an der jeweiligen
Anzapfung B1, B2,... abgenommene Resonatorsignal den Logikwert "0" bzw. den Logikwert "1" bedeuten soll. Die Ausgänge X1, X2,... der Schwellenwertschaltungen S1, S2,...
können an die einzelnen Stufen eines Speichers angeschlossen werden, der das bei der jeweiligen Umsetzung erhaltene
Digitalmuster aufnimmt und bis zum Abruf zur Weiterverwendung speichert.

Je nach dem, wie hoch die Güte der verwendeten Resonatoren
ist und wie hoch man die Schwelle der Schwellenwertschaltungen ansetzt, kann man an den Ausgängen des A/D-Wandlers
ein Logikwertmuster erhalten, das den dem Resonanzzustand
zugeordneten Logikwert nur an einem einzigen Ausgang oder
an mehreren frequenzmäßig nebeneinander befindlichen Ausgängen zeigt. Die
Lage dieses nur an einem einzigen oder an einigen frequenzmäßig benachbarten Resonatoren auftretenden Logikwertes gibt dann in
codierter Weise den Momentanwert des umgesetzten Analogsignals wieder.

Eine Verringerung der Anzahl erforderlicher Resonatoren
kann man dadurch erreichen, daß man ihre Resonanzkurve so breit macht, daß dann, wenn die momentane Frequenz des frequenzmodulierten Trägersignals zwischen den Resonanzfrequenzen zweier benachbarter Resonatoren liegt, diese beiden Resonatoren einen Resonanzzustand annehmen, daß man andererseits die Resonanzkurven aber so schmal macht, daß dann, wenn die momentane Frequenz des modulierten Trägersignals mit der Resonanzfrequenz eines der Resonatoren übereinstimmt, nur dieser eine Resonator in den Resonanzzustand übergeht. Auf diese Weise kann man beispielsweise mit zwei Resonatoren drei verschiedene Analogsignalwerte darstellen, je nach dem, ob zwei benachbarte Resonatoren beide in den Resonanzzustand übergehen oder nur der eine oder nur der andere dieser beiden Resonatoren.

In bevorzugter Weise kann man das an der jeweiligen Anzapfung B1, B2,... der einzelnen Resonatoren R1, R2,... auftretende Hochfrequenzsignal gleichrichten. Dies kann mit einer Diode geschehen, die gleichzeitig die Funktion der zugehörigen Schwellenwertschaltung S1, S2,... übernehmen kann.

Die einzelnen Resonatoren können mit dem Ausgang der Modulatoreinrichtung M über eine Leitung verbunden sein, wie es in der Figur schematisch dargestellt ist. Insbesondere bei sehr hohen Frequenzen empfiehlt es sich jedoch zur Vermeidung von Laufzeiteffekten, alle Resonatoren sternschaltungsartig mit dem Ausgang der Modulatoreinrichtung zu verbinden, wobei die Verbindungsleitungen zwischen dem Ausgang der Modulatoreinrichtung und den einzelnen Resonatoren gleichlang sein können, um gleiche Laufzeiteffekte zu gewährleisten. Man kann aber auch die Zuleitungen zu den einzelnen Resonatoren entsprechend ihrer jeweiligen Resonanzfrequenz mit unterschiedlicher Länge gestalten. Ersatzweise oder zusätzlich kann man auch die Kopplungsglieder E1, E2, ... in Abstimmung auf die jeweilige Resonanzfrequenz der einzelnen Resonatoren unterschiedlich dimensionieren.

Mit der Erfindung ist somit ein Verfahren zur Analog/ Digitalumsetzung verfügbar gemacht worden, bei dem ein Trägerfrequenzsignal mit dem umzusetzenden Analogsignal frequenzmoduliert wird. Das frequenzmodulierte Signal wird parallel in eine Mehrzahl Resonanzeinrichtungen eingespeist, die je auf eine andere Resonanzfrequenz im maximal auftretenden Frequenzhubbereich abgestimmt sind. Je nach dem, ob ein Resonator im Resonanzzustand ist oder nicht, wird ihm ein Logikwert "1" oder ein Logikwert "0" zugeordnet. Das dem Resonanzmuster aller Resonatoren entsprechende Logikwertmuster stellt dann den digitalisierten Momentanwert des Analogsignals dar.

Hans WERBA                           I

u.Z.: K 22 378K/6eb                    27. März 1985

Priorität: 6. April 1984 - Nr. P 34 13 051.9 - Bundesrepublik Deutsch

Analog/Digital-Wandler

## Patentansprüche

1.    Analog/Digital-Wandler mit einer Trägerfrequenzquelle (T) und einer Modulatationseinrichtung (M), mittels
welcher das Trägerfrequenzsignal mit dem umzuwandelnden
Analogsignal moduliert wird,
dadurch  g e k e n n z e i c h n e t ,
daß die Modulationseinrichtung (M) eine Frequenzmodulation
bewirkt,
daß der Modulationseinrichtung (M) eine Mehrzahl von parallel
gespeisten Resonanzeinrichtungen (R1, R2,...) nachgeordnet
ist, die    je eine andere Resonanzfrequenz im  maximal auftretenden Frequenzhubbereich aufweisen und bei Resonanz
einen ersten binären Logikwert (z.B. "1") und bei Nicht-
Resonanz den anderen binären Logikwert (z.B. "0") liefern.

2.    Analog/Digital-Wandler nach Anspruch 1, dadurch gekennzeichnet, daß die einzelnen Resonanzeinrichtungen (R1,
R2,...) je durch einen LC-Parallelresonanzkreis gebildet
sind.

3. Analog/Digital-Wandler nach Anspruch 1, dadurch gekennzeichnet, daß die einzelnen Resonanzeinrichtungen (R1, R2,...) je durch einen LC-Serienresonanzkreis gebildet sind.

4. Analog/Digital-Wandler nach Anspruch 1, dadurch gekennzeichnet, daß die einzelnen Resonanzeinrichtungen (R1, R2,...) je durch eine $\lambda$/4-Leitung, bezogen auf die der jeweiligen Resonanzeinrichtung (R1, R2,...) zugeordnete Resonanzfrequenz, gebildet sind.

5. Analog/Digital-Wandler nach Anspruch 1, dadurch gekennzeichnet, daß die Resonanzeinrichtungen (R1, R2, ...) je durch eine $\lambda$/2-Leitung, bezogen auf die der jeweiligen Resonanzeinrichtung (R1, R2,...) zugeordnete Resonanzfrequenz, gebildet sind.

6. Analog/Digital-Wandler nach Anspruch 1, dadurch gekennzeichnet, daß die einzelnen Resonanzeinrichtungen (R1, R2,...) je durch eine $\lambda$/2-Umwegleitung, wobei $\lambda$ auf eine Wellenlänge der der jeweiligen Resonanzeinrichtung (R1, R2,...) zugeordneten Resonanzfrequenz bezogen ist, gebildet sind.

7. Analog/Digital-Wandler nach Anspruch 1, dadurch gekennzeichnet, daß jede der Resonanzeinrichtungen (R1, R2,...) durch einen Keramikresonator gebildet ist.

8. Analog/Digital-Wandler nach einem der Ansprüche 1 bis 7, dadurch gekennzeichnet, daß jede Resonanzeinrichtung (R1,R2...) durch mehrere zusammengeschaltete Resonatoren gebildet ist.

9. Analog/Digital-Wandler nach einem der Ansprüche 1 bis 8, dadurch gekennzeichnet, daß die einzelnen Resonanzeinrichtungen (R1, R2,...) eingangsseitig mittels je eines Kopplungsglieds (E1, E2,...) an die Modulationseinrichtung
(M) angekoppelt und voneinander entkoppelt sind.

10. Analog/Digital-Wandler nach Anspruch 9, dadurch gekennzeichnet, daß zwischen die Modulationseinrichtung (M)
und jede Resonanzeinrichtung (R1, R2,...) als Kopplungsglied (E1, E2,...) ein Richtkoppler geschaltet ist.

11. Analog/Digital-Wandler nach einem der Ansprüche 1 bis
10, dadurch gekennzeichnet, daß die Ankopplung der eingangsseitig parallelgeschalteten Resonanzeinrichtungen
(R1, R2,...) an den Ausgang der Modulatoreinrichtung (M)
und die Auskopplung der Signale der Resonanzeinrichtungen
(R1, R2,...) über je eine Impedanz (E1, E2,..., K1, K2,...),
vorzugsweise einen Widerstand, eine Induktivität und/oder
eine Kapazität, bewirkt wird.

12. Analog/Digital-Wandler nach einem der Ansprüche 1 bis
11, dadurch gekennzeichnet, daß an jede Resonanzeinrichtung (R1,R2,...)
eine Schwellenwertschaltung (S1, S2,...) zur Erkennung der
beiden möglichen binären Logikwerte angeschlossen ist.

13. Analog/Digital-Wandler nach Anspruch 12, dadurch gekennzeichnet, daß jede Schwellenwertschaltung (S1, S2,...)
durch eine Diode gebildet ist.

14. Analog/Digital-Wandler nach Anspruch 12 oder 13, dadurch gekennzeichnet, daß an die Ausgänge der Schwellenwertschaltungen (S1, S2,...) die Eingänge einzelner Stufen eines
Speichers für das umgesetzte Digitalmuster angeschlossen
sind.

15. Verwendung des Analog/Digital-Wandlers nach einem der
Ansprüche 1 bis 14 als steuerbarer Stufenschalter, dadurch gekennzeichnet, daß die Ausgänge (B1, B2,...; X1, X2,...)
der einzelnen Resonanzeinrichtungen (R1, R2,...) oder
Schwellenwertschaltungen (S1, S2,...) die einzelnen Schalterausgänge bilden und daß der Modulationseinrichtung (M) als
Analogsignal ein Schalterausgangsselektionssignal zugeführt wird, das eine Modulation des Trägersignals auf die
dem jeweils ausgewählten Schalterausgang  zugeordnete Resonanzfrequenz bewirkt.